# EUROPEAN PATENT APPLICATION

(11) **EP 4 424 468 A1**
(43) Date of publication of application: **04.09.2024**
(21) Application number: 22886563.0
(22) Date of filing: 28.09.2022
(51) Int. Cl.: B24B 49/16, B24B 9/00, B24B 21/00, H01L 21/304

(54) **POLISHING DEVICE AND POLISHING METHOD**

(30) Priority: 25.10.2021 JP 2021173866
(71) Applicant: EBARA CORPORATION, Ota-ku, Tokyo 144-8510 (JP)
(72) Inventor: KODERA, Kenji, Tokyo 144-8510 (JP)
(74) Representative: Klang, Alexander H.
(86) International application number: PCT/JP2022/036078
(87) International publication number: WO 2023/074231

(57) **Abstract**

The present invention relates to a polishing apparatus and a polishing method. The polishing apparatus includes a holding stage (4), a polishing head (14), and a control device (1). The control device (1) includes a determination section (1d) that determines a removal of the film (F). The determination unit (1d) determines the removal of the film (F) when a rotational torque value is stabilized at a set torque value.

## Description

### Technical Field

The present invention relates to a polishing apparatus and a polishing method.

### Background Art

A polishing apparatus is known to polish a periphery of a wafer by pressing an polishing tape against the periphery of a substrate (e.g., wafer). Such a polishing apparatus polishes the wafer to be polished based on a predetermined polishing conditions.

### Citation List

### Patent Literature

Patent document 1: Japanese laid-open patent publication No. 2006-066891
Patent document 2: Japanese laid-open patent publication No. 2013-103318
Patent document 3: Japanese laid-open patent publication No. 2017-124471

### Summary of Invention

### Technical Problem

However, the wafer to be polished may have variations (e.g., variations in film thickness and edge cut amount), and by polishing the wafer under a predetermined polishing conditions may result in abnormal polishing such as an under-polishing and an over-polishing.

Therefore, the present invention provides a polishing apparatus and a polishing method that can prevent an under-polishing and an over-polishing.

### Solution to Problem

In an embodiment, there is provided a polishing apparatus comprising: a holding stage configured to rotate a substrate on which a film is formed on a bare wafer; a polishing head configured to polish a periphery of the substrate; and a control device configured to control an operation of the polishing head, the control device comprises: a torque detection unit configured to monitor in a real time a rotational torque value of the holding stage when the periphery of the substrate is polished; a storage unit configured to store the rotational torque value of the holding stage as a set torque value when the bare wafer is polished; and a determination unit configured to determine a removal of the film, the determination unit is configured to determine the removal of the film when the rotational torque value is stabilized at the set torque value.

In an embodiment, the periphery of the substrate comprises an edge portion located radially inwardly of the substrate from an outermost peripheral surface of the substrate, the storage unit is configured to store a set edge torque value when the edge portion of the bare wafer is polished, and the determination unit is configured to determine the removal of the film at the edge portion of the substrate when the rotational torque value at the time of polishing the edge portion of the substrate is stabilized at the set edge torque value.

In an embodiment, the control device comprises a setting unit configured to divide the edge portion of the substrate into a plurality of polishing regions along a radial direction of the substrate and to set a polishing condition for each of the polishing region.

In an embodiment, the setting unit is configured to set at least a movement speed of the polishing head between the polishing regions as the polishing condition.

In an embodiment, when the determination unit determines the removal of the film in at least one of the polishing regions, the control device is configured to control the operation of the polishing head to polish other polishing region excluding the polishing region where the removal of the film has been determined.

In an embodiment, the setting unit is configured to change a movement speed of the polishing head based on a difference between the rotational torque value and the set edge torque value.

In an embodiment, the control device is configured to move the polishing head in a vertical direction with respect to the substrate, and the determination unit is configured to determine the removal of the film in the vertical direction when the rotational torque value is stabilized at the set torque value.

In an embodiment, the control device is configured to move the polishing head in a direction parallel to the substrate, and the control device is configured to move the polishing head in the direction after the determination unit determines the removal of the film in the vertical direction.

In an embodiment, the periphery of the substrate comprises a bevel portion being the outermost peripheral surface of the substrate, the storage unit is configured to store a set bevel torque value when polishing the bevel portion of the bare wafer, and the determination unit is configured to determine the removal of the film on the bevel portion of the substrate when the rotational torque value when polishing the bevel portion of the substrate is stabilized at the set bevel torque value.

In an embodiment, the polishing apparatus comprises a cross-sectional measurement device configured to measure a cross-sectional shape of the bevel portion of the substrate, the storage unit is configured to store a correlation between the cross-sectional shape of the bevel portion measured by the cross-sectional measurement device and the set bevel torque value, and the determination unit is configured to determine the removal of the film on the bevel portion of the substrate based on the correlation.

In an embodiment, there is provided a polishing method for polishing a periphery of a substrate on which a film is formed on a bare wafer while rotating the substrate by a holding stage, comprising: monitoring a rotational torque value of the holding stage in a real time when polishing the periphery of the substrate; comparing the rotational torque value with a set torque value of the holding stage when polishing the bare wafer; and determining a removal of the film when the rotational torque value is stabilized at the set torque value.

In an embodiment, the polishing method comprising: comparing a set edge torque value when polishing an edge portion located radially inward of the substrate from an outermost peripheral surface of the substrate, the edge portion being included in the periphery of the substrate, with the rotational torque value when polishing the edge portion of the substrate, and determining the removal of the film on the edge portion of the substrate when the rotational torque value is stabilized at the set edge torque value.

In an embodiment, the polishing method comprising: dividing the edge portion of the substrate into a plurality of polishing regions along a radial direction of the substrate; and setting a polishing condition for each of the polishing regions.

In an embodiment, the polishing method comprising setting at least a movement speed of the polishing head between the polishing regions as the polishing condition.

In an embodiment, the polishing method comprising polishing other polishing region excluding the polishing region where the removal of the film is determined when determining the removal of the film in at least one of the polishing regions.

In an embodiment, the polishing method comprising changing a movement speed of the polishing head based on a difference between the rotational torque value and the set edge torque value.

In an embodiment, the polishing method comprising: moving the polishing head in a vertical direction with respect to the substrate; and determining the removal of the film in the vertical direction when the rotational torque value is stabilized at the set torque value.

In an embodiment, the polishing method comprising moving the polishing head in a direction parallel to the substrate after determining the removal of the film in the vertical direction.

In an embodiment, the polishing method comprising: comparing a set bevel torque value when polishing a bevel portion, which is the outermost peripheral surface of the substrate, the bevel portion being included in the periphery the substrate, with the rotational torque value when polishing the bevel portion of the substrate; and determining the removal of the film on the bevel portion of the substrate when the rotational torque value is stabilized at the set bevel torque value.

In an embodiment, the polishing method comprising determining the removal of the film on the bevel portion of the substrate based on a correlation between a cross-sectional shape of the bevel portion measured by a cross-sectional measurement device configured to measure the cross-sectional shape of the bevel portion of the substrate and the set bevel torque value.

### Advantageous Effects of Invention

The control device determines the removal of the film based on the rotational torque value and the set torque value of the holding stage. Therefore, the polishing apparatus can polish the substrate with high precision without causing the abnormal polishing such as the under-polishing and the over-polishing.

### Brief Description of Drawings

[FIG. 1A] FIG. 1A is an enlarged cross-sectional view showing a periphery of a substrate;
[FIG. 1B] FIG. 1B is an enlarged cross-sectional view showing the periphery of the substrate;
[FIG. 2] FIG. 2 is a schematic view showing one embodiment of a polishing apparatus;
[FIG. 3] FIG. 3 is a view showing fluctuations in a rotational torque value when polishing a bare wafer;
[FIG. 4] FIG. 4 is a view showing fluctuations in the rotational torque values when polishing a film formed on the bare wafer;
[FIG. 5] FIG. 5 is a view showing an edge portion of a wafer divided into a plurality of polishing regions;
[FIG. 6] FIG. 6 is a view showing a film at a 1st position removed by a polishing head; [FIG. 7] FIG. 7 is a view showing fluctuations in the rotational torque value when polishing the film at the 1st position;
[FIG. 8A] FIG. 8A is a view showing a state of a removal of the film when a movement speed of the polishing head is too fast;
[FIG. 8B] FIG. 8B is a view showing a state of the removal of the film when the movement speed of the polishing head is too fast;
[FIG. 9A] FIG. 9A is a view showing a state of the removal of the film when the polishing head is moved at an appropriate speed;
[FIG. 9B] FIG. 9B is a view showing the state of the removal of the film when the polishing head is moved at an appropriate speed;
[FIG. 10] FIG. 10 is a view showing the rotational torque values that fluctuate depending on a thickness of the film;
[FIG. 11] FIG. 11 is a view showing a head tilt mechanism for tilting the polishing head;
[FIG. 12] FIG. 12 is a view showing the head tilt mechanism for tilting the polishing head;
[FIG. 13A] FIG. 13A is a view showing examples of cross-sectional shapes of the wafer;
[FIG. 13B] FIG. 13B is a view showing examples of the cross-sectional shapes of the wafer;
[FIG. 14A] FIG. 14A is a view showing examples of fluctuations in the rotational torque values when polishing the bevel portion of the bare wafer;
[FIG. 14B] FIG. 14B is a view showing examples of fluctuations in the rotational torque values when polishing the bevel portion of the bare wafer; and
[FIG. 15] FIG. 15 is a view showing an example of a cross-sectional measurement device for measuring the cross-sectional shape of the bevel portion of the wafer.

### Description of Embodiments

Embodiments of the present invention will be described below with reference to the drawings.

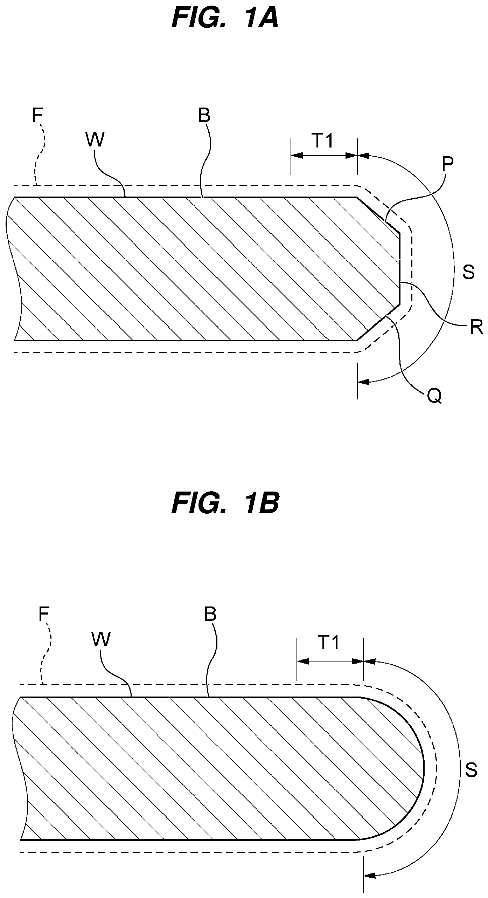

FIGS. 1A and 1B are enlarged cross-sectional views showing a periphery of a substrate. More specifically, FIG. 1A is a cross-sectional view of a so-called straight type substrate, and FIG. 1B is a cross-sectional view of a so-called round type substrate.

An example of the substrate is a wafer. The periphery of the substrate is defined as a region including a bevel portion and an edge portion. In the wafer W shown in FIG. 1A, a bevel portion S is an outermost peripheral surface of the wafer W, which is composed of an upper inclined portion (upper bevel portion) P, a lower inclined portion (lower bevel portion) Q, and a side portion (apex portion) R.

In the wafer W of FIG. 1B, the bevel portion S is a portion that constitutes the outermost peripheral surface of the wafer W and has a curved cross section. An edge portion T1 is an annular flat portion located inside the bevel S in a radial direction. The edge portion T1 is connected to the bevel portion S. The edge portion T1 is also called a top edge portion.

As shown in FIGS. 1A and 1B, the wafer W has a structure in which a film F is formed on a bare wafer B. In this embodiment, the bare wafer B is a bare silicon wafer (Bare-Si). The polishing apparatus described below is configured to remove the film F at the periphery of the wafer W (i.e., the edge portion T1 and the bevel portion S). The detailed structure of the polishing apparatus will be described below.

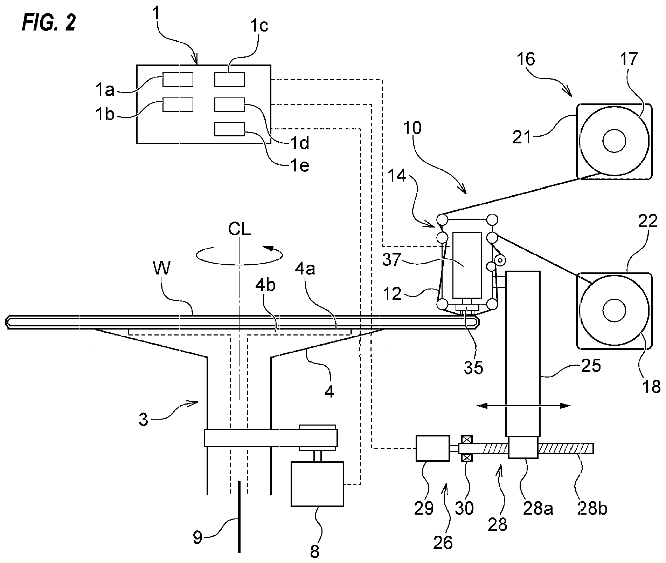

FIG. 2 is a schematic view showing one embodiment of the polishing apparatus. The polishing apparatus includes a wafer rotation device (substrate rotation device) 3 that holds the wafer W, which is an example of the substrate, and rotates the wafer W around a rotation axis CL, and a polishing unit 10 that polishes the periphery of the wafer W. In the embodiment, one polishing unit 10 is provided, but a plurality of polishing units 10 may be provided.

The polishing apparatus further includes a control device 1 that controls operations of the wafer rotation device 3 and the polishing unit 10. The control device 1 is electrically connected to the wafer rotation device 3 and the polishing unit 10.

The control device 1 includes a storage unit 1a that stores programs, and a processing unit 1b that executes calculations according to the programs. The processing unit 1b includes a CPU (central processing unit) or a GPU (graphic processing unit) that performs calculations according to a program stored in the storage unit 1a. The storage unit 1a includes a main storage device (e.g., random access memory) that can be accessed by the processing unit 1b, and an auxiliary storage device (e.g., a hard disk drive or solid state drive) that stores data and programs. The control device 1 is composed of a dedicated computer or a general-purpose computer.

The wafer rotation device 3 includes a holding stage 4 having a wafer holding surface (substrate holding surface) 4a for holding a lower surface of the wafer W, and a motor 8 for rotating the wafer holding surface 4a around the rotation axis CL. A groove 4b is formed in the wafer holding surface 4a, and the groove 4b communicates with the vacuum line 9. When a vacuum is formed in the groove 4b with the wafer W placed on the wafer holding surface 4a, the wafer W is held on the wafer holding surface 4a by vacuum suction.

The polishing unit 10 includes a polishing head 14 that polishes the periphery of the wafer W by a polishing tape 12, and a polishing tape supply mechanism 16 that supplies the polishing tape 12 to the polishing head 14 and collects it from the polishing head 14. In this embodiment, the polishing head 14 is arranged above the edge portion T 1 of the wafer W held on the wafer holding surface 4a.

The polishing tape supply mechanism 16 includes an unwinding reel 17 that unwinds the polishing tape 12 and a take-up reel 18 that winds up the polishing tape 12. Tension motors 21 and 22 are coupled to the unwinding reel 17 and the take-up reel 18, respectively. Each of the tension motors 21 and 22 applies a predetermined torque to the unwinding reel 17 and the take-up reel 18, so that a predetermined tension can be applied to the polishing tape 12.

The polishing tape 12 is supplied to the polishing head 14 so that a polishing surface of the polishing tape 12 faces the wafer W. That is, the polishing tape 12 is supplied from the unwinding reel 17 to the polishing head 14, and the polishing tape 12 used for polishing is collected by the take-up reel 18. One side of the polishing tape 12 constitutes a polishing surface to which abrasive grains are fixed.

The polishing head 14 is fixed to a head support member 25. The head support member 25 is coupled to a polishing-head movement mechanism 26. The polishing-head movement mechanism 26 is configured to move the polishing head 14 and the polishing tape 12 in a radial direction of the wafer holding surface 4a, that is, in the radial direction of the wafer W.

More specifically, the polishing-head movement mechanism 26 includes a ball screw mechanism 28 coupled to the head support member 25 and a motor 29 that operates the ball screw mechanism 28. The ball screw mechanism 28 includes a nut mechanism 28a fixed to the head support member 25, and a screw shaft 28b screwed into the nut mechanism 28a. The screw shaft 28b is rotatably supported by a bearing 30 and coupled to the motor 29. As the motor 29, a servo motor or a stepping motor is used.

The polishing-head movement mechanism 26 is electrically connected to the control device 1, and operations of the polishing-head movement mechanism 26 is controlled by the control device 1. When the control device 1 issues a command to the polishing-head movement mechanism 26 to rotate the motor 29 and the screw shaft 28b in one direction, the nut mechanism 28a and the head support member 25 move outward, and the polishing head 14 and the polishing tape 12 moves outward in the radial direction of the wafer W (radial direction of the wafer holding surface 4a).

When the control device 1 issues a command to the polishing-head movement mechanism 26 to rotate the motor 29 and the screw shaft 28b in an opposite direction, the nut mechanism 28a and the head support member 25 move inward, and the polishing head 14 and the polishing tape 12 are moved inward in the radial direction of the wafer W (radial direction of the wafer holding surface 4a).

As shown in FIG. 2, the polishing head 14 includes a pressing member 35 that presses the polishing tape 12 against the edge portion T1 of the wafer W, and an air cylinder 37 that moves the pressure member 35 in a direction perpendicular to the wafer holding surface 4a (i.e., perpendicular to an upper surface of the wafer W). The polishing head 14 is arranged perpendicularly to the wafer holding surface 4a.

The polishing apparatus is configured to remove a film F of the wafer W. However, there may be variations in the wafers W (e.g., in a thickness of the film F). Therefore, if all wafers W are polished based on a predetermined polishing condition, an abnormal polishing such as an under-polishing or an over-polishing may occur. The control device 1 is then configured to accurately determine a removal of the film F (see FIGS. 1A and 1B). The configuration of the control device 1 will be explained below.

As shown in FIG. 2, the control device 1 includes a torque detection unit 1c that monitors a rotational torque value (in this embodiment, a rotational edge torque value) of the holding stage 4 in a real time when the periphery (in this embodiment, edge portion T1) of the wafer W is polished, and a determination unit 1d that determines the removal of the film F.

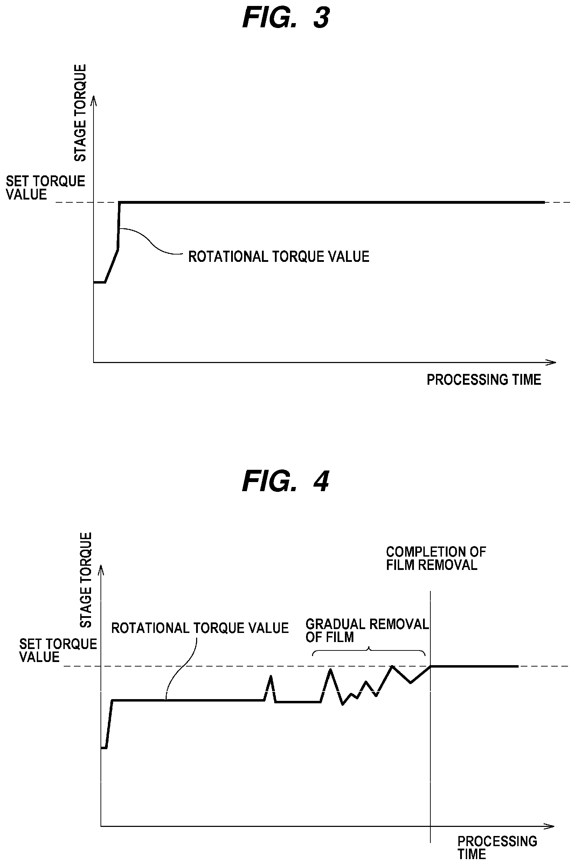

FIG. 3 is a view showing fluctuations in the rotational torque value when polishing the bare wafer. FIG. 4 is a view showing fluctuations in the rotational torque values when polishing a film formed on the bare wafer. In FIGS. 3 and 4, a horizontal axis represents a processing time of the wafer W, and a vertical axis represents a stage torque (i.e., the rotational torque of the holding stage 4).

In the embodiment shown in FIG. 3, the film F is not formed on a bare wafer B. Therefore, even if the polishing head 14 polishes the bare wafer B, a load applied to the motor 8 does not change. Therefore, the rotational torque value of the holding stage 4 is constant during polishing the bare wafer B. The storage unit 1a stores the rotational torque value when polishing the bare wafer B as a set torque value of the holding stage 4. In this embodiment, the rotational torque value is a value when the edge portion T1 of the bare wafer B is polished. The rotational torque value may be called a set edge torque value. The set torque value is a reference value for determining the removal of the film F.

The film F formed on the bare wafer B is made of a softer material than the bare wafer B. Therefore, the load applied to the holding stage 4 when the polishing head 14 polishes the film F is smaller than the load applied to the holding stage 4 when the polishing head 14 polishes the bare wafer B. As a result, the rotational torque value of the holding stage 4, when polishing the film F is started, is smaller than the rotational torque value of the holding stage 4 when polishing the bare wafer B.

As the polishing of the wafer W continues, the film F is gradually removed, and the surface of the wafer W becomes in a state where the film F and the bare wafer B coexist. Then, as shown in FIG. 4, the rotational torque value of the holding stage 4 gradually increases, and eventually reaches the set torque value. As described above, the set torque value corresponds to the rotational torque value when polishing the bare wafer B, so the determination unit 1d compares the current rotational torque value and the set torque value, and determines the removal of the film F when the rotational torque value reaches the set torque value.

In order to more accurately determine the removal of the film F, it is preferable that the determination unit 1d determines the removal of the film F when the rotational torque value is stabilized at the set torque value. In a state where the film F and the bare wafer B coexist, the rotational torque value fluctuates and becomes unstable.

Therefore, after the rotational torque value of the holding stage 4 reaches the set torque value, the control device 1 continues the polishing of the wafer W until the rotational torque value becomes stable. After a predetermined processing time has elapsed, the determination unit 1d determines the removal of the film F when the rotational torque value becomes stable. With such a configuration, the determination unit 1d can determine complete removal of the film F. The predetermined processing time is determined to be a short time in which the over-polishing of the wafer W does not occur.

According to this embodiment, the control device 1 is configured to determine the removal of the film F based on the rotational torque value of the holding stage 4 and the set torque value. Therefore, the polishing apparatus can polish the substrate with an optimal polishing amount without causing abnormal polishing such as the under-polishing or the over-polishing.

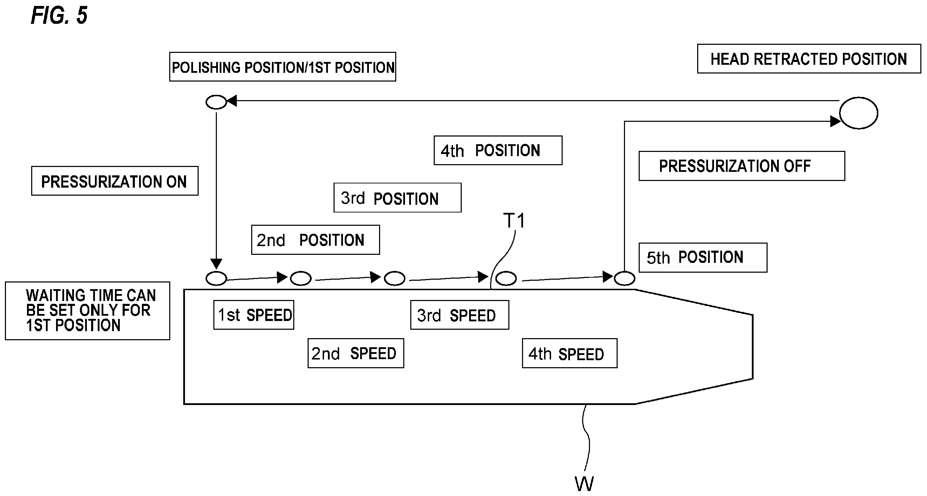

FIG. 5 is a view showing the edge portion of the wafer divided into a plurality of polishing regions. As shown in FIG. 5, the control device 1 includes a setting unit (see FIG. 2) 1e that divides the edge portion T1 of the wafer W into a plurality of polishing regions along the radial direction of the wafer W, and sets polishing conditions for each of the plurality of polishing regions.

In the embodiment shown in FIG. 5, the setting unit 1e divides the edge portion T1 into five polishing regions (see 1st position to 5th position in FIG. 5). However, the number of polishing regions is not limited to the embodiment, and the edge portion T1 may be divided into at least two polishing regions. In this embodiment, the 1st position is arranged on the center side of the wafer W, and the 5th position is arranged on the outermost peripheral surface side of the wafer W.

As shown in FIG. 5, the control device 1 first operates the polishing-head movement mechanism 26 to move the polishing head 14 in a head retracted position to a predetermined polishing position (polishing start position). When the polishing head 14 moves to the polishing position, the control device 1 operates the air cylinder 37 to lower the pressing member 35 together with the polishing tape 12.

The control device 1 brings the polishing tape 12 into contact with the surface (i.e., the film F) of the wafer W by lowering the pressing member 35. The control device 1 is configured to move the polishing head 14 in a direction perpendicular to the surface of the wafer W. As shown in FIG. 5, by setting the waiting time at the 1st position, the polishing head 14 removes the film F at the 1st position (i.e., the polishing start position).

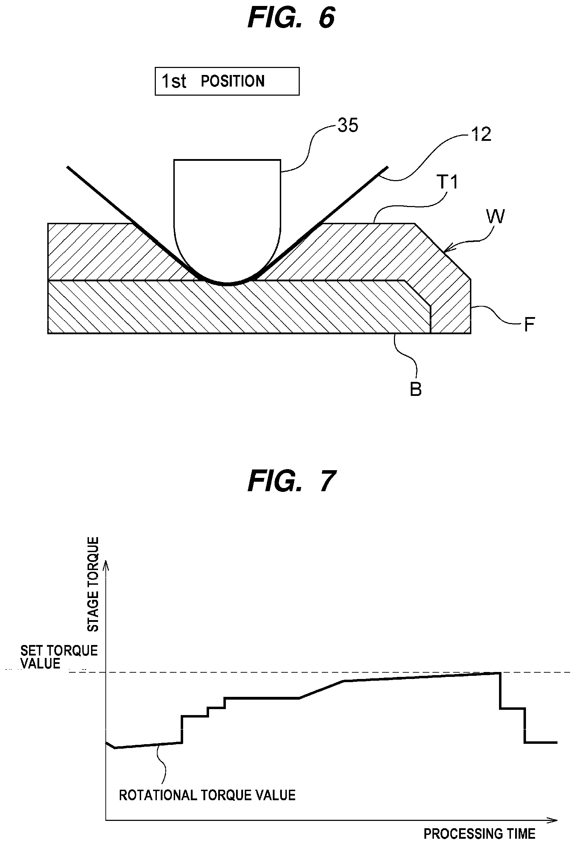

FIG. 6 is a view showing the film at the 1st position removed by the polishing head. FIG. 7 is a view showing fluctuations in the rotational torque value when polishing the film at the 1st position. In FIG. 7, a horizontal axis shows the processing time of the wafer W, and a vertical axis shows the stage torque. As shown in FIG. 7, as the polishing of the film F at the 1st position progresses, the rotational torque value of the holding stage 4 gradually increases, and eventually reaches the set torque value. The determination unit 1d determines to remove the film F in the vertical direction when the rotational torque value is stabilized at the set torque value, and determines that the polishing head 14 reaches the bare wafer B.

After the film F at the 1st position is removed, the control device 1 operates the polishing-head movement mechanism 26 to move the polishing head 14 from the 2nd position to the 5th position. As described above, the setting unit 1e of the control device 1 is configured to set the polishing conditions for each of the polishing regions. More specifically, the setting unit 1e sets at least a movement speed of the polishing head 14 between the polishing regions as the polishing conditions. Other polishing conditions include, for example, the pressing force of the air cylinder 37 and a supply speed of the polishing tape 12 to the polishing head 14.

In the embodiment shown in FIG. 5, the setting unit 1e moves the polishing head 14 from the 1st position to the 2nd position at a 1st speed, and from the 2nd position to the 3rd position at a 2nd speed. Further, the setting unit 1e moves the polishing head 14 from the 3rd position to the 4th position at a 3rd speed, and from the 4th position to the 5th position at a 4th speed.

The setting unit 1e may determine each speed from the 1st speed to the 4th speed based on the thickness of the film F. The storage unit 1a stores data regarding the thickness of the film F. Therefore, the setting unit 1e can determine each speed from the 1st speed to the 4th speed based on the data of the film F stored in the storage unit 1a.

In one embodiment, the thickness of the film F may be measured by a film thickness measurement device (not shown) built into the polishing apparatus or a film thickness measurement device (not shown) arranged outside the polishing apparatus. In other embodiments, the thickness of the film F may be determined based on film thickness information of the wafer having the same structure as the wafer W to be polished. In yet another embodiment, the thickness of the film F may be determined based on experimental results obtained when a wafer having the same structure as the wafer W was polished in the past.

The amount of film F removed depends on the movement speed of the polishing head 14. When the movement speed of the polishing head 14 is slow, the amount of film F removed becomes large. Conversely, when the polishing head 14 moves at a high speed, the amount of film F removed becomes small. Therefore, the setting unit 1e may slow down the movement speed of the polishing head 14 in the polishing region where the film F is thick, and increase the movement speed of the polishing head 14 in the polishing region where the film F is thin. With such a configuration, the polishing time required to remove the film F can be shortened, and as a result, a throughput of the polishing apparatus can be improved.

In one embodiment, the control device 1 may finish the polishing of the wafer W after moving the polishing head 14 to the 5th position. In this case, the control device 1 operates the air cylinder 37 at the 5th position to raise the pressing member 35 (see pressurization OFF in FIG. 5). After that, the control device 1 moves the polishing head 14 to the head retracted position and finishes the polishing the wafer W.

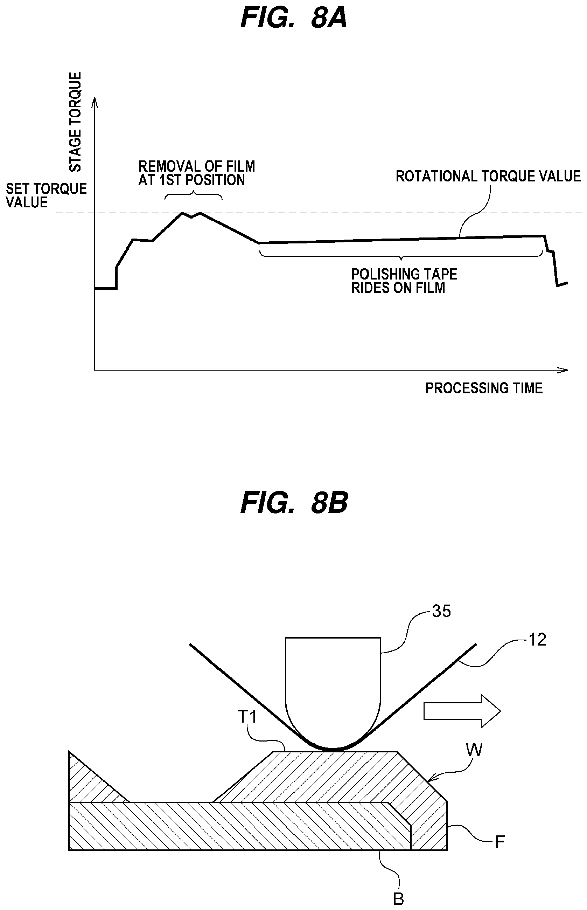

FIGS. 8A and 8B are views showing a state of the removal of the film when the movement speed of the polishing head is too fast. As shown in FIG. 8A, the control device 1 lowers the pressing member 35 to remove the film F at the 1st position. Thereafter, the control device 1 operates the polishing-head movement mechanism 26 to move the polishing head 14 from the 1st position to the 5th position.

As shown in FIGS. 8A and 8B, if the movement speed of the polishing head 14 is too fast, the polishing tape 12 rides on the film F, and the polishing head 14 cannot remove the film F. Therefore, the control device 1 may feedback-control the operation of the polishing head movement mechanism 26 based on the current rotational torque value detected by the torque detection unit 1c. More specifically, when the rotational torque value becomes lower than the set torque value due to the movement of the polishing head 14 in the radial direction of the wafer W, the control device 1 may slow down the movement speed of the polishing head 14 until the rotational torque value reaches the set torque value.

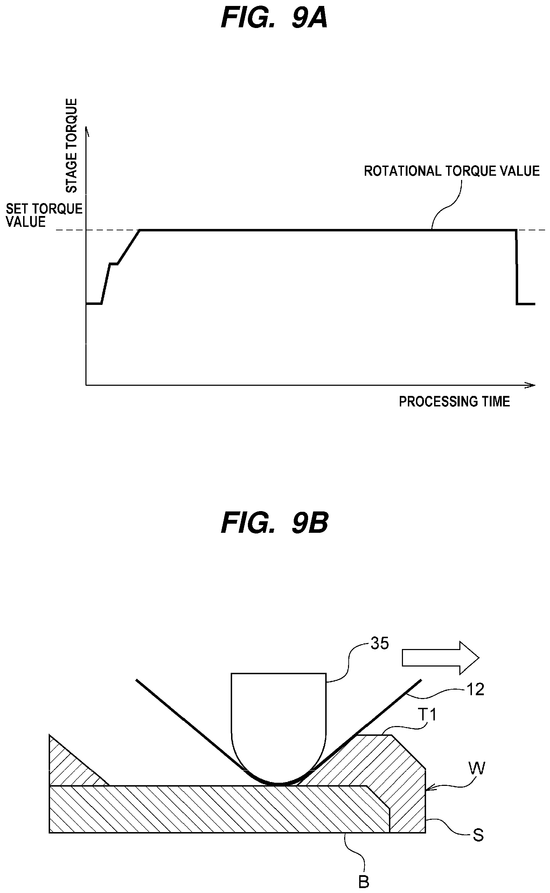

FIGS. 9A and 9B are views showing the state of the removal of the film when the polishing head is moved at an appropriate speed. The control device 1 changes the movement speed of the polishing head 14 so that a difference between the rotational torque value and the set torque value becomes smaller. With such a configuration, the control device 1 can always move the polishing head 14 at an optimal movement speed, and as a result, as shown in FIGS. 9A and 9B, the polishing head 14 can reliably remove the film F. In this manner, the control device 1 (more specifically, the setting unit 1e) may change the movement speed of the polishing head 14 based on the difference between the rotational torque value and the set torque value.

In the embodiment described above, the control device 1 finishes the polishing of the wafer W after moving the polishing head 14 to the 5th position, but in one embodiment, the control device 1 moves the polishing head 14 to the 5th position. After this, the polishing head 14 may be moved to the 1st position again, and the polishing of the wafer W may be repeated. In other words, the control device 1 may operate the polishing head movement mechanism 26 to reciprocate the polishing head 14.

In this case, the control device 1 may move the polishing head 14 from the 5th position to the 1st position while pressing the polishing tape 12 against the wafer W. The control device 1 may move the polishing head 14 from the 5th position to the 1st position with the polishing tape 12 separated from the wafer W.

When reciprocating the polishing head 14, the control device 1 may move the polishing head 14 at a speed faster than a reference movement speed (i.e., reference speed). The reference speed is a speed at which the film F of the wafer W can be removed in the shortest time, and is determined based on the accumulated polishing data of the wafer W. The storage unit 1a stores polishing data regarding the reference speed.

By reciprocating the polishing head 14 at a speed faster than the reference speed, the polishing head 14 can gradually remove the film F multiple times. Therefore, the torque detection unit 1c can accurately detect slight fluctuations in the rotational torque value. As a result, the determination unit 1d can determine the removal of the film F with higher accuracy.

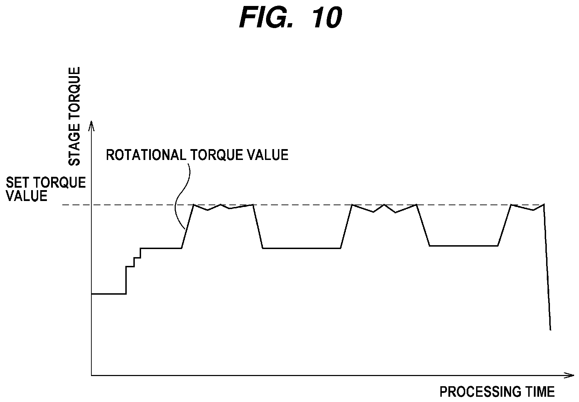

FIG. 10 is a view showing the rotational torque values that fluctuate depending on the thickness of the film. In FIG. 10, a horizontal axis represents a processing time, and a vertical axis represents a stage torque. As shown in FIG. 10, when the polishing head 14 polishes the film F, the rotational torque value becomes smaller than the set torque value. Conversely, when the polishing head 14 polishes the bare wafer B (i.e., a portion of the wafer W where the film F does not exist), the rotational torque value reaches the set torque value.

In this manner, the determination unit 1d can determine a presence or an absence of the film F based on a magnitude of the rotational torque value detected by the torque detection unit 1c. The control device 1 can automatically change the polishing conditions during polishing the wafer W based on this determination result.

More specifically, when the determination unit 1d determines to remove the film F in at least one of the plurality of polishing regions, the control device 1 controls the operation of the polishing head 14 to polish the other polishing regions excluding the polishing region where the film F is determined to be removed. This configuration allows the control device 1 to prevent the over-polishing of parts where the film F is not present by the polishing head 14.

In one embodiment, the control device 1 may increase the movement speed of the polishing head 14 in the polishing region where the removal of the film F has been determined, and may decrease the movement speed of the polishing head 14 in other polishing regions. In one embodiment, the control device 1 may raise the pressing member 35 of the polishing head 14 when the polishing head 14 reaches the polishing region where the film F is determined to be removed.

When reciprocating the polishing head 14, the control device 1 moves the polishing head 14 from the 1st position to the 5th position a predetermined number of times, and then controls the polishing-head movement mechanism 26 to avoid polishing a specific position. For example, the control device 1 may reciprocate the polishing head 14 from the 1st position to the 5th position three times, and reciprocate from the 1st position to the 2nd position from the fourth time onwards. In other words, the control device 1 omits polishing the wafer W from the 3rd position to the 5th position from the fourth time onwards.

In one embodiment, the control device 1 may previously polish the wafer W from the 1st position to the 5th position by a polishing head (not shown) including a polishing tape for final polishing the wafer W. By this polishing, the determination unit 1d can determine the presence or the absence of the film F on the wafer W based on the rotational torque value detected by the torque detection unit 1c. Therefore, the control device 1 may automatically determine the polishing conditions based on the state of the wafer W determined by the determination unit 1d.

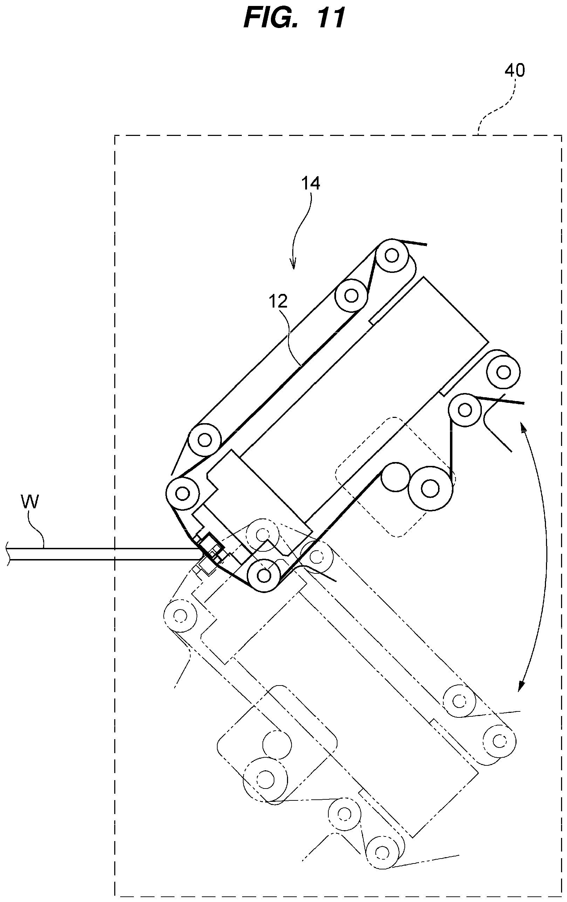

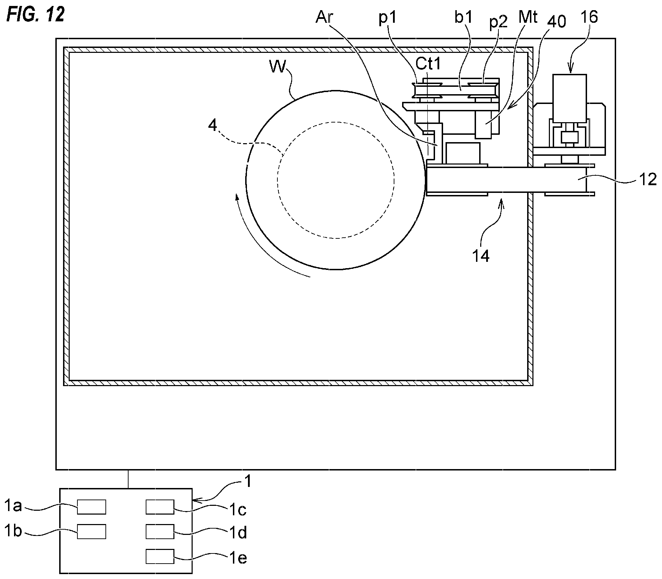

FIGS. 11 and 12 are views showing a head tilt mechanism for tilting the polishing head. As shown in FIGS. 11 and 12, the polishing apparatus may include a head tilt mechanism 40 that tilts the polishing head 14 with respect to the surface of the wafer W. The head tilt mechanism 40 includes an arm Ar fixed to the polishing head 14 and a motor Mt that rotates the arm Ar by a predetermined angle around a rotation axis Ct. Although not shown, the polishing apparatus also includes the polishing-head movement mechanism 26 in this embodiment.

The polishing head 14 is fixed to one end of the arm Ar, and the arm Ar is configured to be rotatable around the rotation axis Ct parallel to a tangential direction of the wafer W. The other end of the arm Ar is coupled to the motor Mt via pulleys p1, p2 and a belt b1. As the motor Mt rotates clockwise and counterclockwise by a predetermined angle, the arm Ar rotates by a predetermined angle around a rotation axis Ct1.

The control device 1 is electrically connected to the head tilt mechanism 40 and is configured to control operations of the head tilt mechanism 40. The polishing head 14 is configured to polish the bevel portion S, which is the outermost peripheral surface of the wafer W, by the head tilt mechanism 40.

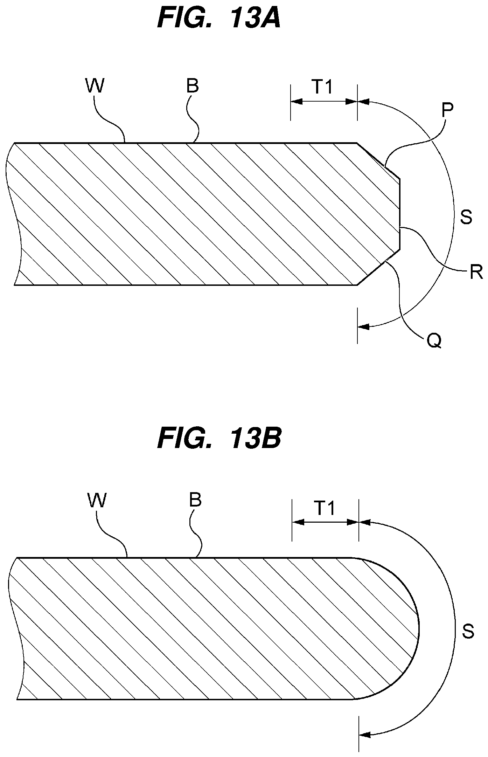

FIGS. 13A and 13B are views showing examples of cross-sectional shapes of the wafer. As shown in FIGS. 13A and 13B, the cross-sectional shapes of the wafer are roughly classified into two types, but the standards for the wafer dimensions are wide and various shapes exist.

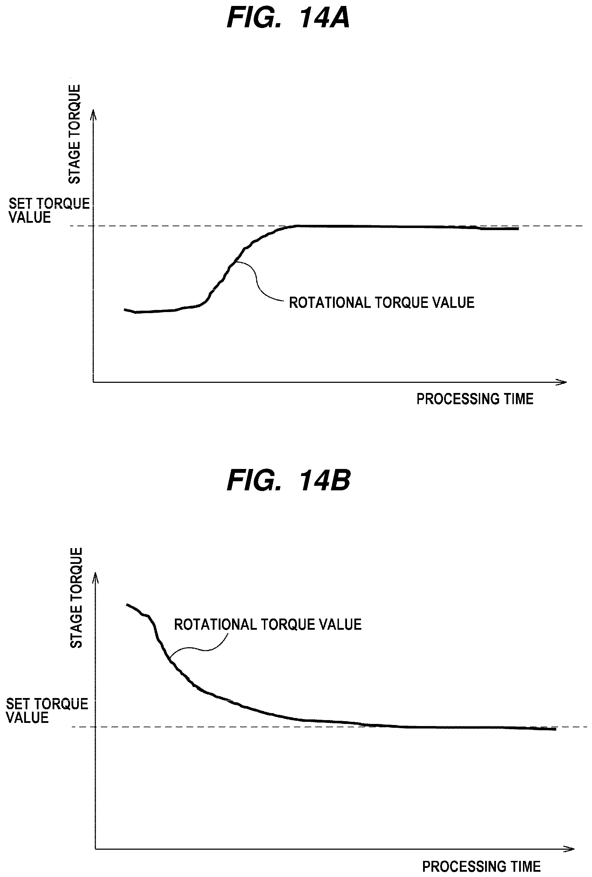

FIGS. 14A and 14B are views showing examples of fluctuations in rotational torque values when polishing the bevel portion of the bare wafer. As shown in FIGS. 14A and 14B, at the bevel portion, waveforms of the rotational torque values showing various trends are obtained depending on factors such as the cross-sectional shape of the wafer, an angle at which the polishing head 14 is pressed, and the pressing force.

Therefore, the storage unit 1a stores the rotational torque values as the set torque value of the holding stage 4 when the bare wafers B having different cross-sectional shapes are polished. In the present embodiment, this rotational torque value is a value when the bevel portion S of the bare wafer B is polished, so it may be called a set bevel torque value. The set torque value is a value for determining the removal of the film F, and is a value when the rotational torque value is stable for a predetermined processing time. In other words, the set torque value corresponds to a value when the amount of change in the rotational torque value becomes smaller than a predetermined fluctuation range.

The control device 1 operates the head tilt mechanism 40 to rotate the polishing head 14 by a predetermined angle. When the polishing head 14 polishes the bevel portion S of the wafer W, the torque detection unit 1c detects the rotational torque value (rotational bevel torque value in this embodiment) of the holding stage 4 at the bevel portion S of the wafer W. The determination unit 1d determines to remove the film F on the bevel portion S of the wafer W when the rotational torque value detected by the torque detection unit 1c becomes stable at the set torque value.

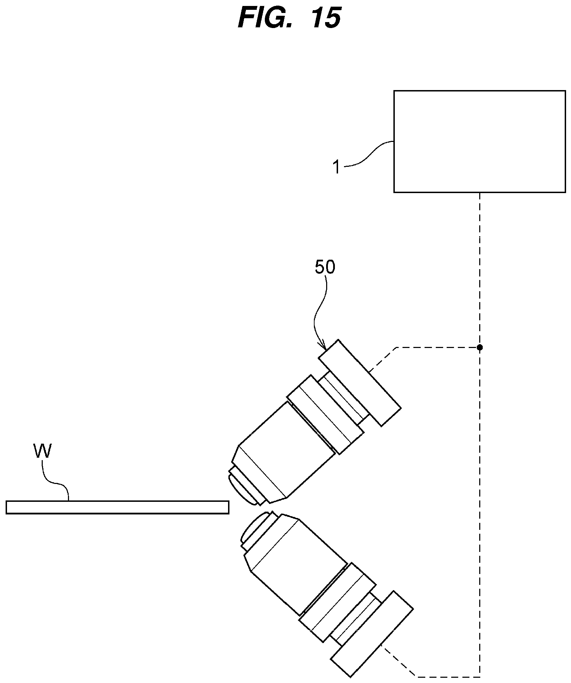

FIG. 15 is a view showing an example of a cross-sectional measurement device for measuring the cross-sectional shape of the bevel portion of the wafer. As shown in FIG. 15, the polishing apparatus may include a cross-sectional measurement device 50 that measures a cross-sectional shape of the bevel portion S of the wafer W, or may take in data on the cross-sectional shape measured by a cross-sectional measurement device (not shown) arranged outside the polishing apparatus.

The cross-sectional measurement device 50 is electrically connected to the control device 1. The storage unit 1a stores a correlation between the cross-sectional shape of the beveled portion S of the wafer W measured by the cross-sectional measurement device 50 and the set torque value corresponding to the cross-sectional shape of the beveled portion S. The determination unit 1d is configured to determine the removal of the film F from the bevel portion S based on this correlation.

More specifically, the control device 1 can determine the set torque value of the bevel section S of the wafer W to be polished from the cross-sectional shape of the bevel portion S imaged by the cross-sectional measurement device 50 based on the correlation stored in the storage unit 1a. With such a configuration, the determination unit 1d can determine whether the current rotational torque value detected by the torque detection unit 1c has reached the set torque value. As in the embodiment described above, it is desirable that the determination unit 1d determines to remove the film F when the rotational torque value is stabilized at the set torque value.

Also in this embodiment, the control device 1 may perform a tilt operation of the polishing head 14 only once, or may perform the tilt operation multiple times. In this manner, the control device 1 may operate the head tilt mechanism 40 an arbitrary number of times.

In the embodiment described above, the configuration of the control device 1 that determines the removal of the film F is described, but the storage unit 1a may store a program that determines the removal of the film F. This program includes a command to monitor in a real time the rotational torque value of the holding stage 4 when polishing the periphery of the wafer W, to compare the rotational torque value with the set torque value of the holding stage 4 when polishing the bare wafer B, and to determine the removal of the film F when the rotational torque value is stabilized at the set torque value.

The program may include a command to determine the removal of the film F at the edge portion T1 of the wafer W when the rotational edge torque value becomes stable at the set edge torque value stored in the storage unit 1a. Furthermore, the program may include a command to divide the edge portion T1 of the wafer W into a plurality of polishing regions along the radial direction of the wafer W, and to set the polishing conditions for each of the plurality of polishing regions.

In this case, the program may include, as the polishing condition, at least a command to set the movement speed of the polishing head between the polishing regions, and to change the movement speed of the polishing head 14 based on a difference between the rotational edge torque value and the set edge torque value.

When the determination unit 1d determines that the film F is removed in at least one of the polishing regions, the program may include a command to polish other polishing regions excluding the polishing region where the film F is determined to be removed.

When the polishing head 14 is moved vertically with respect to the wafer W and the rotational torque value is stabilized at the set torque value, the program may include a command to determine the removal of the film F in the vertical direction, and to determine the reaching of the polishing head 14 to the bare wafer B. In this case, the program may include a command to move the polishing head 14 in a direction parallel to the wafer W after the determination unit 1d determines that the polishing head 14 has reached the bare wafer B.

The program may include a command to determine the removal of the film F of the bevel portion S when the rotational bevel torque value is stabilized at the set bevel torque value stored in the storage unit 1a. In this case, the program may determine the removal of the film F of the bevel portion S based on a correlation between the cross-sectional shape of the bevel portion S and the set bevel torque value stored in the storage unit 1a. In this case, the program may include a command to determine the removal of the film F of the bevel portion S based on a correlation between the cross-sectional shape of the bevel portion S measured by the cross-sectional measurement device 50 and the set bevel torque value, stored in the storage unit 1a.

In the embodiment described above, the polishing apparatus includes the polishing head 14 that removes the film F formed on the upper surface of the bare wafer B, but the polishing head 14 is configured to remove the film F formed on the lower surface of the bare wafer B. In one embodiment, the polishing apparatus may include the polishing head 14 arranged above the wafer W and a polishing head (not shown) arranged below the wafer W. With such a configuration, the polishing apparatus can remove the film F formed on the upper and lower surfaces of the bare wafer B.

The above embodiments are described for the purpose of practicing the present invention by a person with ordinary skill in the art to which the invention pertains. Although preferred embodiments have been described in detail above, it should be understood that the present invention is not limited to the illustrated embodiments, but many changes and modifications can be made therein without departing from the appended claims.

### Industrial Applicability

The invention is applicable to a polishing apparatus and a polishing method.

### Reference Signs List

- 1: control device
- 1a: storage unit
- 1b: processing unit
- 1c: Torque detection unit
- 1d: determination unit
- 1e: setting unit
- 3: wafer rotation device
- 4: holding stage
- 4a: wafer holding surface
- 4b: groove
- 8: motor
- 9: vacuum line
- 10: polishing unit
- 12: polishing tape
- 14: polishing head
- 16: polishing tape supply mechanism
- 17: unwinding reel
- 18: take-up reel
- 21,22: tension motor
- 25: head support member
- 26: polishing-head movement mechanism
- 28: ball screw mechanism
- 28a: nut mechanism
- 28b: screw shaft
- 29: motor
- 30: bearing
- 35: pressing member
- 37: air cylinder
- 40: head tilt mechanism
- 50: cross-sectional measurement device

## Claims

1. A polishing apparatus comprising:
a holding stage configured to rotate a substrate on which a film is formed on a bare wafer;
a polishing head configured to polish a periphery of the substrate; and
a control device configured to control an operation of the polishing head,
wherein the control device comprises:
a torque detection unit configured to monitor in a real time a rotational torque value of the holding stage when the periphery of the substrate is polished;
a storage unit configured to store the rotational torque value of the holding stage as a set torque value when the bare wafer is polished; and
a determination unit configured to determine a removal of the film,
wherein the determination unit is configured to determine the removal of the film when the rotational torque value is stabilized at the set torque value.

2. The polishing apparatus according to claim 1, wherein the periphery of the substrate comprises an edge portion located radially inwardly of the substrate from an outermost peripheral surface of the substrate,
wherein the storage unit is configured to store a set edge torque value when the edge portion of the bare wafer is polished, and
wherein the determination unit is configured to determine the removal of the film at the edge portion of the substrate when the rotational torque value at the time of polishing the edge portion of the substrate is stabilized at the set edge torque value.

3. The polishing apparatus according to claim 2, wherein the control device comprises a setting unit configured to divide the edge portion of the substrate into a plurality of polishing regions along a radial direction of the substrate and to set a polishing condition for each of the polishing region.

4. The polishing apparatus according to claim 3, wherein the setting unit is configured to set at least a movement speed of the polishing head between the polishing regions as the polishing condition.

5. The polishing apparatus according to claim 3 or 4, wherein when the determination unit determines the removal of the film in at least one of the polishing regions, the control device is configured to control the operation of the polishing head to polish other polishing region excluding the polishing region where the removal of the film has been determined.

6. The polishing apparatus according to any one of claims 2 to 5, wherein the setting unit is configured to change a movement speed of the polishing head based on a difference between the rotational torque value and the set edge torque value.

7. The polishing apparatus according to any one of claims 1 to 6, wherein the control device is configured to move the polishing head in a vertical direction with respect to the substrate, and
wherein the determination unit is configured to determine the removal of the film in the vertical direction when the rotational torque value is stabilized at the set torque value.

8. The polishing apparatus according to claim 7, wherein the control device is configured to move the polishing head in a direction parallel to the substrate, and
wherein the control device is configured to move the polishing head in the direction after the determination unit determines the removal of the film in the vertical direction.

9. The polishing apparatus according to claim 1, wherein the periphery of the substrate comprises a bevel portion being the outermost peripheral surface of the substrate,
wherein the storage unit is configured to store a set bevel torque value when polishing the bevel portion of the bare wafer, and
wherein the determination unit is configured to determine the removal of the film on the bevel portion of the substrate when the rotational torque value when polishing the bevel portion of the substrate is stabilized at the set bevel torque value.

10. The polishing apparatus according to claim 9, wherein the polishing apparatus comprises a cross-sectional measurement device configured to measure a cross-sectional shape of the bevel portion of the substrate,
wherein the storage unit is configured to store a correlation between the cross-sectional shape of the bevel portion measured by the cross-sectional measurement device and the set bevel torque value, and
wherein the determination unit is configured to determine the removal of the film on the bevel portion of the substrate based on the correlation.

11. A polishing method for polishing a periphery of a substrate on which a film is formed on a bare wafer while rotating the substrate by a holding stage, comprising:
monitoring a rotational torque value of the holding stage in a real time when polishing the periphery of the substrate;
comparing the rotational torque value with a set torque value of the holding stage when polishing the bare wafer; and
determining a removal of the film when the rotational torque value is stabilized at the set torque value.

12. The polishing method according to claim 11, comprising:
comparing a set edge torque value when polishing an edge portion located radially inward of the substrate from an outermost peripheral surface of the substrate, the edge portion being included in the periphery of the substrate, with the rotational torque value when polishing the edge portion of the substrate, and
determining the removal of the film on the edge portion of the substrate when the rotational torque value is stabilized at the set edge torque value.

13. The polishing method according to claim 12, comprising:
dividing the edge portion of the substrate into a plurality of polishing regions along a radial direction of the substrate; and
setting a polishing condition for each of the polishing regions.

14. The polishing method according to claim 13, comprising setting at least a movement speed of the polishing head between the polishing regions as the polishing condition.

15. The polishing method according to claim 13 or 14, comprising polishing other polishing region excluding the polishing region where the removal of the film is determined when determining the removal of the film in at least one of the polishing regions.

16. The polishing method according to any one of claims 12 to 15, comprising changing a movement speed of the polishing head based on a difference between the rotational torque value and the set edge torque value.

17. The polishing method according to any one of claims 11 to 16, comprising:
moving the polishing head in a vertical direction with respect to the substrate; and
determining the removal of the film in the vertical direction when the rotational torque value is stabilized at the set torque value.

18. The polishing method according to claim 17, comprising moving the polishing head in a direction parallel to the substrate after determining the removal of the film in the vertical direction.

19. The polishing method according to claim 11, comprising:
comparing a set bevel torque value when polishing a bevel portion, which is the outermost peripheral surface of the substrate, the bevel portion being included in the periphery the substrate, with the rotational torque value when polishing the bevel portion of the substrate; and
determining the removal of the film on the bevel portion of the substrate when the rotational torque value is stabilized at the set bevel torque value.

20. The polishing method according to claim 19, comprising determining the removal of the film on the bevel portion of the substrate based on a correlation between a cross-sectional shape of the bevel portion measured by a cross-sectional measurement device configured to measure the cross-sectional shape of the bevel portion of the substrate and the set bevel torque value.
